# EUROPÄISCHE PATENTSCHRIFT

(11) **EP 3 137 847 B1**
(45) Veröffentlichungstag und Bekanntmachung des Hinweises auf die Patenterteilung: **13.04.2022**
(21) Anmeldenummer: 15721571.6
(22) Anmeldetag: 29.04.2015
(51) Int. Cl.: G01B 5/00, G01D 11/24

(54) **INTERFEROMETRISCHER WEGSENSOR ZUR INTEGRATION IN WERKZEUGMASCHINEN UND HALBLEITER-LITHOGRAFIESYSTEMEN**
INTERFEROMETRIC DISPLACEMENT SENSOR FOR INTEGRATION INTO MACHINE TOOLS AND SEMICONDUCTOR LITHOGRAPHY SYSTEMS
CAPTEUR DE DÉPLACEMENT INTERFÉROMÉTRIQUE DESTINÉ À ÊTRE INTÉGRÉ DANS DES MACHINES-OUTILS ET DES SYSTÈMES DE LITHOGRAPHIE À SEMI-CONDUCTEUR

(30) Priorität: 30.04.2014 DE 102014006305
(43) Veröffentlichungstag der Anmeldung: 08.03.2017
(73) Patentinhaber: Attocube Systems AG, 85540 Haar (DE)
(72) Erfinder: ZECH, Martin, D-85464 Finsing (DE); THURNER, Klaus, 85622 Feldkirchen (DE)
(74) Vertreter: DTS Patent- und Rechtsanwälte Schnekenbühl und Partner mbB
(86) Internationale Anmeldenummer: PCT/EP2015/000872
(87) Internationale Veröffentlichungsnummer: WO 2015/165587

(56) Entgegenhaltungen:
- WO-A1-91/09271
- US-A1- 2011 051 143
- None

## Beschreibung

Die Erfindung betrifft ein Interferometer, insbesondere ein Interferometer, das als Wegsensor zur Integration in Werkzeugmaschinen, insbesondere in Halbleiter-Litographiesystemen einsetzbar ist. Außerdem betrifft die Erfindung ein optisches Längenmesssystem zum Messen von Absolutabständen und/oder relativen Positionsbewegungen zwischen einem ersten und einem zweiten Maschinenteil.

Längenmesssysteme zum Vermessen einer eindimensionalen Relativbewegungen zwischen einem ersten und einem zweiten Maschinenteil sind hinreichend bekannt und finden heutzutage in einer großen Anzahl von Maschinen Anwendung, insbesondere zum Vermessen der relativen Lage von Maschinenkopf und Maschinenbett bei Zerspanungs- oder Schleifmaschinen oder zum Vermessen der relativen Lage von Sensorkopf/Belichtungskopf gegenüber einem Probenschlitten wie vielfach in der Elektronenmikroskopie oder der Halbleiter-Lithografie verwendet.

WO 91/09271 zeigt eine Interferometeranordnung.

Auf Grund der stetig steigenden Anforderungen an Wiederhol-, Absolutgenauigkeit und Robustheit hat sich der optische Glasmaßstab durchgesetzt, welcher aus einem Messkopf und einem Glasmaßstab mit aufgebrachtem Gitter mit bekannter Gitterperiodizität besteht und Relativbewegungen zwischen Messkopf und Maßstab berührungslos ermittelt. Typische Gitterperiodizitäten liegen heutzutage bei 10-20 *µ*m, wodurch bei geeigneter elektronischer Interpolation hierbei eine Positionsauflösung von bis zu einem Nanometer (nm) erreichbar ist. In der DE 10262008 B4 wird ein Längenmeßsystem mit einem Glasmaßstab beschrieben.

Seit wenigen Jahren sind auch holografische Gitter erhältlich, die gegenüber dem herkömmlichen Glasmaßstab eine kleinere Periodizität aufweisen (< 1 *µ*m) und somit auch eine erhöhte Auflösung bieten, typischerweise im 0.1nm-Bereich. In der DE4128595B4 wird eine holographische Skala beschrieben.

Magnetische Maßstäbe, wie sie beispielsweise in der DE19729312A1 beschrieben werden, sind eine kostengünstige Alternative zu den optischen Messsystemen, kommen aber auf Grund ihrer geringeren Genauigkeit hauptsächlich in der Automobilbranche, nicht aber in der höchstpräzisen Fertigung oder Lithografie zur Anwendung.

Aufgabe der vorliegenden Erfindung war es daher, eine Echtzeit-Längenmesssystem mit verbesserten Eigenschaften bereitzustellen, insbesondere mit einer höheren Genauigkeit, mit mehr Anwendungsmöglichkeiten auch bei mehr als einem Freiheitsgrad, mit einer verringerten Notwendigkeit einer externen Kalibrierung, einer erhöhten Bandbreite der Messung, einem verringerten Bauraum oder der Eignung, die Bewegung eines Maschinenwerkzeuges wie beispielsweise einem Bohrer oder einem Fräser direkt zu vermessen.

Die Aufgabe der Erfindung wird mit einer Vorrichtung nach Anspruch 1 gelöst. Vorteilhafte Ausgestaltungen sind in den Unteransprüchen angegeben.

Insbesondere wird die Aufgabe gelöst durch ein Interferometer zur Echtzeitmessung von Absolutabständen und/oder relativen Positionsbewegungen zwischen einem ersten und einem zweiten Maschinenteil, umfassend eine bevorzugt mit dem ersten Maschinenteil verbindbaren Messeinheit und eine bevorzugt mit dem zweiten Maschinenteil verbindbaren Reflektoreinheit, wobei die Messeinheit ein Gehäuse mit mindestens einer Wand aus wärmeleitendem Material umfasst, wobei in dem Gehäuse mehrere Messelemente angeordnet sind, wobei die Messelemente umfassen: eine Laserquelle, insbesondere einen DFB-Laser, ein Peltier-Element und eine digitale Steuerung, bevorzugt eine FPGA-Steuerung, wobei die Messelemente thermisch an der Wand des Gehäuses aus wärmeleitendem Material angekoppelt sind.

Durch den Einsatz eines Interferometers zur Echtzeitmessung von Absolutabständen bzw. von relativen Positionsbewegungen zwischen zwei Maschinenteilen ist es möglich, eine sehr viel höhere Genauigkeit bei der Ermittlung der Abstände bzw. Relativbewegungen zu realisieren - damit kann die intrinsische Beschränkung der Absolutgenauigkeit des Glasmaßstabes prinzipbedingt durch die Laserinterferometrie überwunden werden. Während im Stand der Technik die Interferometrie in der Regel nur zur Kalibrierung von Maschinen eingesetzt wurde, kann nun erfindungsgemäß durch die Interferometriemessung im Echtzeitbetrieb die Bewegung bzw. der Abstand zwischen zwei Maschinenteilen in sehr viel höherer Absolutgenauigkeit gemessen werden, als dies mit dem Glasmaßstab oder der Holographie-Skala möglich ist. Der Echtzeitbetrieb erlaubt hierbei ein Einbinden des Sensors in die Maschinensteuerung und somit einen geschlossenen Regelkreis mit dem/der sich in der Maschine befindlichen Aktuator(en).

Die Messung der Absolutabstände wird hierbei bevorzugt dadurch erreicht, dass die digitale Steuerung, insbesondere eine FPGA-Steuerung die Wellenlänge des Lasers, insbesondere eines DFB-Lasers mittels des Peltier-Elementes periodisch verstellt (thermische Veränderung der Wellenlänge), wobei während dessen das Interferenzsignal durch die FPGA-Steuerung kontinuierlich vermessen und analysiert wird. Bei Kenntnis der Wellenlängenvariation dLambda, der Basiswellenlänge Lambda, und der augenscheinlichen Positionsveränderung dx lässt sich hierbei der Arbeitsabstand "x" zwischen Messkopf und Reflektor nach dLambda/Lambda=dx/x bestimmen. Die genaue Ermittlung der Wellenlänge Lambda und der Modulationsamplitude dLambda erfolgt hierbei durch Analyse des Transmissionssignals einer Molekularabsorptionszelle. Bevorzugterweise wird hierbei die Wellenlänge dermaßen moduliert, dass mehrere Absoprtionsminima der Molekularabsoprtionszelle überstrichen werden (entsprechend einem dLambda von mehreren Nanometern). Die Kenntnis der Wellenlänge/Lage der Absorptionsminima der Gaszelle erlaubt die präzise Bestimmung von dLambda und Lambda, und somit eine direkt Berechnung des Absolutabstandes "x".

Die Lösung der Aufgabe erfolgt erfindungsgemäß dadurch, dass unter Verzicht auf eine aktive Kühlung die Messelemente durch Konvektion gekühlt werden, indem sie an die wärmeleitende Außenwand des Gehäuses angekoppelt werden. Im Stand der Technik bestand das Vorurteil, dass aufgrund der hohen Temperaturempfindlichkeit der Interferometriemessung eine aktive Kühlung unerlässlich sei. Durch die Vermeidung der aktiven Kühlung mittels der thermischen Ankopplung der wärmeentwickelnden Messelemente innerhalb der Messeinheit und der Kühlung über Konvektion ist eine Bauform bereitgestellt worden, die den Einsatz eines Interferometers bei der Echtzeitmessung von Absolutabständen bzw. von relativen Positionsbewegungen zwischen zwei Maschinenteilen erstmals ermöglicht. Erst damit ist es möglich, das Interferometer ultra-kompakt aufzubauen und vorteilhaft auch hermetisch abgeschirmt gegen Umwelteinflüsse auszugestalten und damit die Möglichkeit zu erhalten, das Interferometer bzw. die Messeinheit einerseits und die Reflektoreinheit andererseits auf zwei Maschinenteilen zu montieren und hierüber die Bewegung bzw. den Abstand zwischen diesen Maschinenteilen in Echtzeit zu messen. So kann das erfindungsgemäße Interferometer in Maschinen integriert werden, beispielsweise in Koordinatenmeßmaschinen (CMM), an industriellen Hutschienen des Standards DIN EN 60715 befestigt werden oder an Elektromotoren, Verbrennungsmotoren, oder Gasturbinen angeflanscht werden.

Das Interferometer besteht aus einer Messeinheit und einer Reflektoreinheit. Die bevorzugt auf dem ersten Maschinenteil befestigte Messeinheit bzw. das Basismodul enthält insbesondere die optischen Komponenten zur Erzeugung des Messstrahles, der dann auf die bevorzugt auf dem zweiten Maschinenteil befestigten Reflektoreinheit gerichtet wird und dessen reflektierter Strahl dann durch weitere Komponenten der Messeinheit ausgewertet wird, so dass in Echtzeit der Absolut-Abstand und/oder auch eine Abstandsveränderung zwischen der Messeinheit und der Reflektoreinheit - und damit zwischen dem ersten und dem zweiten Maschinenteil - mittels Interferometrie bestimmt werden kann. Bevorzugt besteht das Interferometer aus einem fest mit dem ersten Maschinenteil verbundenen optoelektronischen Sensorkopf bzw. fasergekoppeltem Messkopf und mehreren fest mit dem zweiten bzw. den weiteren Maschinenteilen verbundenen Reflektoreinheiten.

Die Reflektoreinheit besteht aus einem optischen Element, das die von der Messeinheit ausgesandte Strahlung zumindest teilweise reflektieren kann. Die optische Reflektoreinheit kann bevorzugt Planspiegel, Retroreflektoren oder auch maschinell bearbeitete Materialien umfassen. Die optische Reflektivität kann hierbei bevorzugt einen weiten Bereich annehmen, wodurch sowohl unbeschichtete Gläser (Reflektivität von ~ 4%) als auch Materialien mit hoher Reflektivität wie Metalle (Reflektivität > 90%) als Reflektoren verwendet werden können. Insbesondere eignet sich auch Silizium (Reflektivität von ~ 40%) als Reflektormaterial. Damit kann die Reflektoreinheit auch bevorzugt eine beispielsweise polierte Oberfläche oder eine Oberfläche bestimmter Güte auf dem Maschinenteil selbst sein.

Das Gehäuse weist mindestens eine Wand aus wärmeleitendem Material auf, so dass über diese Wand die Wärme an die Umgebungsluft abgegeben werden kann. Als wärmeleitendes Material eignet sich ein Material mit einer Wärmeleitfähigkeit *lambda* von mehr als 30 W/(m · K) bei 0°C, insbesondere von mehr als 100, besonders bevorzugt von mehr als 150, bevorzugt von mehr als 200, besonders bevorzugt von mehr als 230. Die Wärmeleitfähigkeit beträgt bei 0°C in trockener Bedingung bei Aluminium 236, bei Gold 314, bei Silber 429, bei reinem Kupfer 401, bei Handelsware Kupfer 240-380, bei Messing 120, bei Wolfram 167 und bei Nickel 85. Bevorzugt wird als wärmeleitendes Material eines dieser Materialien oder eine Kombination dieser Materialien eingesetzt. Besonders bevorzugt wird Aluminium oder eine Aluminiumlegierung eingesetzt.

Das Gehäuse ist bevorzugt hermetisch gegenüber Umwelteinflüssen abgeschirmt ausgebildet. Da durch die Kühlung über Konvektion keine aktive Kühlung mehr erforderlich ist können Lüftungsöffnungen im Gehäuse entfallen und dadurch eine hermetische Abschirmung des Gehäuses gegenüber Umwelteinflüssen realisiert werden. So ist bevorzugt eine Abschirmung gemäß einer Schutzart nach der Schutzklasse IP 54 bis IP67 realisierbar. Die Schutzart gibt die Eignung von elektrischen Betriebsmitteln (zum Beispiel Geräte, Leuchten und Installationsmaterial) für verschiedene Umgebungsbedingungen an, zusätzlich den Schutz von Menschen gegen potentielle Gefährdung bei deren Benutzung.

Die Messelemente umfassen eine Laserquelle, bevorzugt einen DFB-Laser sowie ein Peltier-Element. DFB-Laser (Distributed feedback laser - Laser mit verteilter Rückkopplung) sind Laserdioden, in denen das aktive Material periodisch strukturiert ist. Die Strukturen wechselnder Brechzahl bilden ein eindimensionales Interferenzgitter bzw. Interferenzfilter (Bragg-Spiegel). Die Interferenz führt zu wellenlängenselektiver Reflexion und bildet die optische Rückkopplung des Lasers. Bevorzugt ist die Laserquelle durch einen DFB-Laser gegeben welcher über eine Gaszelle, insbesondere eine Molekularabsorptionszelle, Wellenlängen-stabilisiert ausgeführt ist.

Mit dem Peltier-Element lässt sich die Temperatur des Lasers zwecks Wellenlängenabstimmung einstellen.

Besonders bevorzugt ist der DFB-Laser mit einem integrierten Peltier-Element in einer Laser-Diode zusammen ausgeführt, besonders bevorzugt als Butterfly Laser-Diode.

Außerdem umfassen die Messelemente eine digitale Steuerung, bevorzugt eine FPGA-Steuerung. Ein Field Programmable Gate Array (FPGA) ist ein integrierter Schaltkreis (IC) der Digitaltechnik, in den eine logische Schaltung programmiert werden kann.

Weiterhin können die Messelemente bevorzugt einen AD/DA-Wandler, bevorzugt bestehend aus einem Analog-Digital-Umsetzer und einen Digital-Analog-Umsetzer und/oder ein Spannungsreglermodul, bevorzugt einen bzw. mehrere Point-of-Load-Regler umfassen. Diese Messelemente sind bevorzugt auch - einzeln oder alle - thermisch an der Wand des Gehäuses angekoppelt. Die Messelemente sind thermisch an der Wand des Gehäuses aus wärmeleitendem Material angekoppelt. Dadurch wird die Wärme der Messelemente über die Außenwand des Gehäuses an die Umgebungsluft abgegeben. Besonders bevorzugt ist das Gehäuse an einem weiteren Teil in flächigem Kontakt montiert, beispielsweise ist das Gehäuse an das erste Maschinenteil angebracht oder es ist im flächigen Kontakt mit einem Kühlblock in einem Steuerschrank untergebracht. Durch Kontakt der Außenwand des Gehäuses mit diesem weiteren Teil kann die Wärme von der Wand des Gehäuses an das weitere Teil abgegeben werden. Besonders bevorzugt ist auf dem Gehäuse eine Wärmeleitfolie aufgebracht, die auch mit dem weiteren Teil in Kontakt steht und somit für eine Ableitung der Wärme aus der Wand des Gehäuses über die Wärmeleitfolie in das weitere Teil sorgt. Wärmeleitfolie außen und innen/ Wärmeleit-Pads/ Wärmeleit-Paste In einem weiteren Ausführungsbeispiel der vorliegenden Erfindung ist ein Interferometer vorgesehen, bei dem die Messeinheit einen abgesetzten Messkopf umfasst, der mit der Messeinheit mittels eines Lichtwellenleiters gekoppelt ist. Die Strahlführung des Interferometers kann damit sowohl durch freie Strahlführung als auch faserbasiert erfolgen.

In der Grundausführung ist das Interferometer nach der vorliegenden Erfindung im Freistrahlmessverfahren einsetzbar. Dabei wird der Messstrahl aus dem Gehäuse der Messeinheit über einen Sensorausgang ausgekoppelt und durch die Luft auf die Reflektoreinheit gerichtet. Bei der hier beschriebenen Ausführungsform ist (zusätzlich) ein abgesetzter Messkopf vorgesehen, der mit der Messeinheit über einen optischen Leiter verbunden ist und den Messstrahl aus der Messeinheit in einen von der Messeinheit abgesetzten Messkopf leitet. Von diesem Messkopf wird dann der Messstrahl auf die Reflektoreinheit gerichtet und die reflektierte Strahlung auch wieder detektiert. Bevorzugt wird der abgesetzte Messkopf mittels eines Lichtwellenleiters, insbesondere eines Glasfaserkabels, an die Messeinheit gekoppelt. Diese faserbasierte Messung erfordert auf bekannte Weise die Kompensation der im Lichtwellenleiter auftretenden optischen Effekte. Der Lichtwellenleiter kann eine Länge von bis zu 100m, bevorzugt bis zu 1000m, besonders bevorzugt bis zu 5000m aufweisen.

Besonders bevorzugt sind in einer Messeinheit mehrere Messstrahlen parallel einsetzbar, insbesondere bevorzugt über eine Anzahl n von Sensorausgängen. Die Anzahl n ist bevorzugt 1, 2, 3, 4, 5, 6, 7, 8, 9 oder 10. Denkbar sind auch Realisierungen von 20, 30 oder 40. Diese Sensorausgänge können im Freistrahlverfahren oder als abgesetzte Messköpfe fasergekoppelt ausgeführt sein. Besonders bevorzugt sind sowohl Sensorausgänge für das Freistrahlverfahren als auch für die Ankopplung von abgesetzten Messköpfen vorgesehen. Bevorzugt sind drei Sensorausgänge vorgesehen, besonders bevorzugt drei Sensorausgänge für das Freistrahlverfahren. Weiterhin bevorzugt sind drei Sensorausgänge für fasergekoppelte Messköpfe vorgesehen. Weiterhin bevorzugt sind drei Sensorausgänge für das Freistrahlverfahren vorgesehen sowie ein, zwei oder drei weitere fasergekoppelte Messköpfe. Damit ist es möglich, neben einer absoluten Abstandsmessung auch einen Nick-, einen Gier- bzw. einen Rollwinkel zwischen zwei Maschinenteilen zu ermitteln sowie einen Versatz zwischen den Werkstücken in x- und y-Richtung (wobei die z-Richtung der Abstand zwischen den Maschinenteilen bezeichnen soll). Außerdem ist es insbesondere durch den Einsatz der abgesetzten faserbasierten Messköpfe möglich, mehrere Maschinenteile und deren Bewegungsverhalten untereinander, d.h. auch mehr als zwei Maschinenteile, zu messen. Damit ist ein optisches Längenmesssystem zum Messen von Absolutabständen und relativen Positionsbewegungen zwischen einem ersten und einem zweiten Maschinenteil bzw. zwischen einem ersten und einer Mehrzahl von Maschinenteilen bzw. zwischen mehreren Maschinenteilen untereinander, sowie den während des Verfahrens eines oder mehrerer Maschinenteile auftretenden Maschinenschwingungen und Führungsfehlern - insbesondere Winkelfehler - relativ zum ersten Maschinenteil bereitgestellt.

In der vorliegenden Erfindung ist ein Interferometer vorgesehen, bei dem die Messelemente faseroptische Komponenten und miniaturisierte Digitalelektronik, beispielsweise wie sie in der Telekommunikationstechnik zur Anwendung kommen, umfassen, insbesondere dass die Messelemente ein Interface-Board, ein Field-Programmable-Gate-Array (FPGA)-Board, ein Laser-Board, und ein Optik-Board umfassen. Hierdurch ist eine miniaturisierte Ausgestaltung der Messeinheit des Interferometers möglich. Bevorzugt ist vorgesehen, eine Kombination von mehreren der angesprochenen Boards auf einem Board zu realisieren. Besonders bevorzugt werden standardisierte faseroptische Komponenten aus der Telekommunikation verwendet. Die Laserquelle ist bevorzugt ein DFB-Laser, welcher über eine Gaszelle Wellenlängen-stabilisiert ausgeführt ist. Die Stabilisierung der Wellenlänge erfolgt hierbei bevorzugt bis auf 50ppb.

Die Kommunikation zwischen den Sensorköpfen und den Boards erfolgt hierbei bevorzugt faseroptisch. Die Kommunikation zwischen den verbleibenden Boards erfolgt elektrisch analog bzw. digital.

Bevorzugt ist die FPGA-Steuerung als FPGA-Board ausgebildet und erlaubt die Datenaufnahme und -Prozessierung in Echtzeit. Das FPGA-Board beinhaltet bevorzugt einen FPGA mit schneller Taktung, insbesondere mit einer Taktung von mehr als 70 MHz, einen Quad-Analog-Digital-Konverter, sowie eine Mehrzahl an Digital-Analog-Wandlern. Das FPGA-Board ist hierbei die zentrale Rechenstelle des Interferometers, welche nicht nur die simultane Bestimmung der Positionen/Winkel aller Achsen in Echtzeit errechnet, sondern auch für eine Vielzahl von weiteren Aufgaben verantwortlich ist. Bevorzugt übernimmt das FPGA-Board auch die Stabilisierung der Wellenlänge des DFB-Lasers, der sich bevorzugt auf einem Laser-Board befindet, über eine sich bevorzugt in einem Optik-Board befindliche Molekularabsoprtionszelle. Darüber hinaus übernimmt das FPGA-Board bevorzugt auch die thermische Regelung des DFB-Lasers über ein sich bevorzugt auf dem Laser-Board befindliches Peltier-Element sowie die Modulation/Demodulation der Laserwellenlänge zur Erzeugung eines Quadratursignals oder die dynamische Anpassung von Filtereigenschaften und Systemparametern als Funktion der Verfahrgeschwindigkeit und des Abstandes des zweiten Maschinenteils und die Reduktion von periodischen Nichtlinearitäten auf unter 1 Nanometer. Des Weiteren lassen sich über einen sich auf dem FPGA-Board befindlichen Prozessor System- und Schnittstellenparameter mittels eines webinterfaces bzw. einer Internetschnittstelle einstellen.

Durch eine Taktung des FPGA von 50 MHz, besonders bevorzugt von 80 MHz ist es möglich, eine Latenzzeit von weniger als 500ns zu erreichen. Damit ist eine Echtzeitauswertung ermöglicht. Besonders bevorzugt werden im FPGA Rechenschritte parallel ausgeführt, insbesondere mit Software Pipelining - dies dient der Parallelverarbeitung von Befehlen eines einzelnen Threads.

Das Laserboard ist im Wesentlichen für die Signalgeneration und -Detektion zuständig und enthält bevorzugt eine fasergekoppelte DFB-Laserquelle zur Erzeugung für die Interferometrie notwendigen kohärenten Laserlichts, weiterhin bevorzugt ein Peltier-Element und weiterhin bevorzugt einen Temperatursensor zur Temperatursteuerung des Lasers, sowie weiterhin bevorzugt vier oder mehr Fotodetektoren und bevorzugt weiterhin dazugehörige Verstärkerschaltungen. Hierbei übernehmen bevorzugt drei (oder mehrere) Fotodetektoren die Messung der Interferenzintensitäten von den drei (oder mehreren) Sensorausgängen, wobei ein weiterer Fotodetektor das Transmissionssignal einer sich bevorzugt in dem Optik-Board befindlichen Molekularabsorptionszelle bestimmt.

Das Optik-Board ist für das Signal-Routing zuständig und enthält bevorzugt nebst einer Vielzahl an Faserkopplern und Isolatoren auch eine Molekularabsorptionszelle, welche zur Wellenlängenstabilisierung verwendet wird. Das Optik-Board ist des Weiteren bevorzugt mit den Sensorausgängen bzw. den externen bzw. abgesetzten Sensor- bzw. Messköpfen mittels Faseroptik verbunden.

Das Interface-Board erlaubt die Echtzeit-Datenkommunikation mit Peripheriegeräten über moderne Echtzeitschnittstellen. Bevorzugt sind hier Schnittstellen für die in der Industrie typischen Feldbussen (CAN, Profinet, Profibus, Ethercat) sowie bevorzugt auch Ethernet sowie besonders bevorzugt digitale Echtzeitprotokollen integriert, so z.B. AquadB und proprietäre serielle Protokolle. Über die selbigen Schnittstellen lassen sich auch analoge Sinus/Cosinus-Signale (Quadratursignale) zur Positionsübertragung ausgeben. Weiter bevorzugt ist ein weiterer Anschluss zur Verbindung einer Umweltkompensationseinheit vorgesehen - dies erlaubt die Bestimmung des in der Umgebungsluft vorherrschenden optischen Brechnungsindexes, welcher eine Absolutgenauigkeit des Laserinterferometers von besser 1ppm (parts per million) in ambienten Bedingungen erlaubt. So bestehen über das Interface-Board verschiedene Möglichkeiten der Positionsausgabe. Insbesondere umfasst dies digitale ABquer, digitale serielle und analoge sin/cos Schnittstellen, sowie die in der Industrie üblichen Feldbusse (Canopen, CAN, Profibus, Profinet, Ethercat, SPI). Besonders bevorzugt ist eine Webschnittstelle vorgesehen. Hierdurch ist ein zügiges Einrichten der Mechanik, eine Bestimmung der Signalqualität/stärke des Sensors, als auch eine Justage aller Schnittstellenparameter ermöglicht.

In der vorliegenden Erfindung ist ein Interferometer vorgesehen, bei dem das Gehäuse Außenabmessungen von weniger als 75 mm x 75 mm x 200 mm, bevorzugt von weniger als 50 mm x 50 mm x 165 mm aufweist. Besonders bevorzugt weist das Volumen des Gehäuses mit seinen Außenabmessungen weniger als 0,001125 m^3 auf, insbesondere weniger als 0,0004125 m^3.

In der vorliegenden Erfindung ist ein Interferometer vorgesehen, bei dem das Gehäuse in mindestens einem Bereich Kühlrippen aufweist, welche eine Thermalisierung mit den umgebenden Luftmassen befördert.

Durch das Vorsehen einer vergrößerten Oberfläche, insbesondere im Bereich des Gehäuses an der Außenfläche, in dem auf der Innenseite der Gehäusewand ein Messelement angeordnet ist, wird die Wärmeübertragung an die Umgebung des Gehäuses befördert. Besonders bevorzugt werden Kühlrippen an der Außenseite des Gehäuses vorgesehen. Diese Kühlrippen sind bevorzugt integriert mit dem Gehäuse ausgebildet. Vorteilhaft wird dadurch ein Wärmeaustausch, d.h. eine Thermalisierung mit den umgebenden Luftmassen erreicht.

In einem weiteren Ausführungsbeispiel der vorliegenden Erfindung ist ein Interferometer vorgesehen, bei dem an der Außenseite des Gehäuses eine Gewindebuchse vorgesehen ist. Die Gewindebuchse ist bevorzugt in einem Abstand "d" von der Stirnseite des Gehäuses angebracht, welcher der Brennweite "f" der Kollimatoren entspricht und somit den Einfluss von thermischen Fluktuationen auf die Abstands- bzw. Positionsmessung - im Falle einer Messung mittels Freistrahl - auf ein Minimum reduziert.

Alternativ zu Gewindesacklöchern können in das Gehäuseprofil auch Nuten eingepresst werden, welche die Befestigung an einem ersten Maschinenteil mittels Nutensteinen ermöglicht. Bevorzugt werden Adapterbleche an das Gehäuse montiert, welche bevorzugt die Befestigung an Hutschienen des Standards DIN EN 60715 erlauben. Das Interferometer ist in diesem Fall bevorzugt in einem Schaltschrank montiert, die Sensorköpfe über Lichtleiter angesteuert.

In der vorliegenden Erfindung ist ein Interferometer vorgesehen, bei dem die Reflektoreinheit mindestens einen optischen Reflektor, bevorzugt mindestens drei optische Reflektoren umfasst. Der Anzahl an Sensorausgängen, seien sie für einen Freistrahl oder für einen fasergekoppelten Messkopf, entsprechen die Anzahl an Reflektoren, die an dem zweiten Maschinenteil befestigt werden. Diese Reflektoren können einzeln ausgebildet sein oder eine Anzahl von einzelnen Reflektoren auf einem gemeinsamen Träger oder auch eine größere reflektierende Fläche, die als Reflektor für unterschiedliche Messstrahlen dient. So ist es beispielsweise möglich, dass drei Messstrahlen auf eine Reflektorfläche auf der Stirnseite des zweiten Maschinenteils gerichtet werden und die Auftreffbereiche der Messstrahlen auf dieser Reflektorfläche untereinander mit einem vorbestimmten Abstand d1, d2, d3 beabstandet sind. So lässt sich durch die Abstandsmessung dieser drei Messpunkte auf der Reflektorfläche bei bekanntem d1, d2 und d3 neben dem Abstand auch der Gier- und der Nickwinkel (Verkippung) des zweiten Maschinenteils zum ersten Maschinenteil bestimmen.

Damit bestehen bevorzugt mehrere fundamentale Meßmodi. Insbesondere sind dies die inkrementelle Messung einer linearen Positionsveränderung, die inkrementelle Messung einer oder mehrerer Winkelveränderungen durch die Verwendung zweier oder mehrerer Messstrahlen welche sich zueinander in bekanntem Abstand und Winkel befinden, sowie die Messung eines absoluten Positionsabstandes zwischen Messkopf und Reflektor durch kontrollierte Variation der Wellenlänge der Laserquelle und Analyse des dadurch entstehenden Interferenzmusters.

In einem weiteren Ausführungsbeispiel der vorliegenden Erfindung ist ein Interferometer vorgesehen, bei dem die digitale Steuerung, bevorzugt das Field Programmable Gate Array, eingerichtet ist, eine Positionsermittlung der Reflektoreinheit und/oder eine Temperatur- und Wellenlängenregelung durchzuführen. Durch eine schnelle Taktung des FPGAs und/oder durch Parallelberechnung von Positionsinformationen kann die Bandbreite der Positionsbestimmung sehr hoch ausfallen, so dass diese bis zu 100MHz betragen kann. Die Auflösung der Positionsveränderung beträgt dabei je nach Lichtwellenlänge bis zu 1 Pikometer (10⁻¹² m).

In einem weiteren Ausführungsbeispiel der vorliegenden Erfindung ist ein Interferometer vorgesehen, bei dem das Interferometer mit drei Messachsen, bevorzugt mit 5 Messachsen, besonders bevorzugt mit 7 Messachsen versehen ist.

Diese können sowohl als Freistrahl ausgeführt sein, aber auch mit entfernt gelegenen Messköpfen, die mittels einer Glasfaser optisch angesteuert und ausgelesen werden.

Das Basismodul besitzt hierbei typischerweise drei Meßachsen oder auch eine größere Zahl an Meßachsen, welche bei der Relativbewegungsmessung zwischen einem ersten und einem zweiten Maschinenteil sowohl die Bestimmung des absoluten und relativen Abstandes als auch von Verkippung um die Hochachse (Gieren) und um die Querachse (Nicken) ermöglicht.

In einem weiteren Ausführungsbeispiel der vorliegenden Erfindung ist ein Interferometer vorgesehen, bei dem zusätzlich eine Einrichtung zur Kompensation der (beispielsweise umweltbedingten) Variation des Brechungsindexes der Luft vorgesehen ist. Bevorzugt ist hierfür eine Einrichtung zum Anschluss weiterer Elektronik vorgesehen (extern oder in das Gehäuse integriert), welche die Variation des Brechungsindexes der Luft auf der Länge der Messstrecke durch Messung des Luftdrucks, der Lufttemperatur, oder der Luftfeuchtigkeit kompensiert.

Die Aufgabe der Erfindung wird auch gelöst durch ein optisches Längenmesssystem zum Messen von Absolutabständen und/oder relativen Positionsbewegungen zwischen einem ersten und einem zweiten Maschinenteil bestehend aus einem (fest) mit dem ersten Maschinenteil verbundenen optoelektronischen Messeinheit eines erfindungsgemäßen Interferometers oder einem (fest) mit dem ersten Maschinenteil verbundenen abgesetzten Messkopf, der mit einer Messeinheit eines erfindungsgemäßen Interferometers fasergekoppelt ist und mindestens einer (fest) mit dem zweiten Maschinenteil verbundenen Reflektoreinheit.

Dadurch ist ein optisches Längenmesssystem zur Echtzeit-Messung zwischen einem ersten und einem zweiten Maschinenteil bzw. einer Mehrzahl von Maschinenteilen bzw. zwischen mehreren Maschinenteilen untereinander, sowie den während des Verfahrens eines oder mehrerer Maschinenteile auftretenden Maschinenschwingungen und Führungsfehlern - insbesondere Winkelfehler - relativ zum ersten Maschinenteil bereitgestellt.

Weitere vorteilhafte Ausgestaltungen sind in den Figuren gezeigt. Die Figuren zeigen hierbei:
- Figur 1: eine schematische Darstellung eines erfindungsgemäßen Interferometers;
- Figur 2: eine geschlossene Draufsicht auf ein Ausführungsbeispiel der Messeinheit gemäß der vorliegenden Erfindung;
- Figur 3: eine offene Draufsicht auf ein Ausführungsbeispiel der Messeinheit gemäß der vorliegenden Erfindung;
- Figur 4: ein erstes Ausführungsbeispiel eines optischen Längenmesssystems zur Echtzeit-Messung zwischen einem ersten und einem zweiten Maschinenteil und
- Figur 5: ein zweites Ausführungsbeispiel eines optischen Längenmesssystems zur Echtzeit-Messung zwischen einem ersten, einem zweiten und einem dritten Maschinenteil.

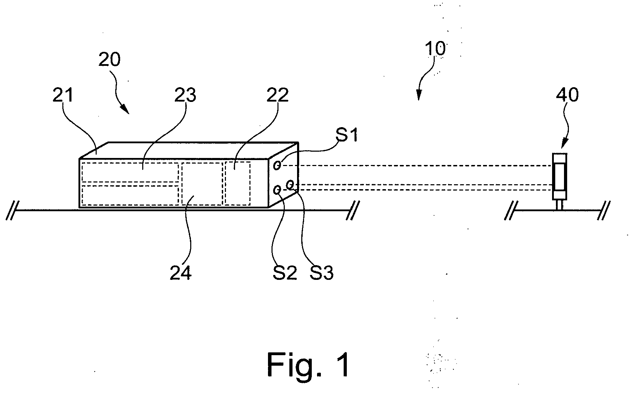

Figur 1 zeigt eine schematische Darstellung eines erfindungsgemäßen Interferometers 10. Das Interferometer 10 umfasst eine Messeinheit 20 als Basismodul und eine davon abgesetzte Reflektoreinheit 40. Die Messeinheit 20 besteht aus einem Gehäuse 21, in dem eine Laserquelle 22, eine digitale Steuerung 23 und ein Peltier-Element 24 aufgenommen ist. Die Laserquelle 22, die digitale Steuerung 23 und das Peltier-Element 24 sind mit der Innenseite der Wandung des Gehäuses 21 thermisch gekoppelt, indem sie mit dem Gehäuse mittels einer Wärmeleitfolie verklebt sind.

Über drei Auslässe an der Stirnseite des Gehäuses 21 können drei Messtrahlen S1, S2 und S3 von der Messeinheit 20 auf die Reflektoreinheit 40 gerichtet werden. Die von dort reflektierten Strahlen werden von der Messeinheit 20 detektiert und über die digitale Steuerung 23 in Echtzeit ausgewertet.

Hierdurch sind Relativbewegungen und/oder Absolutabstände zwischen dem Messmodul 20 und der Reflektoreinheit 40 in Echtzeit erfassbar.

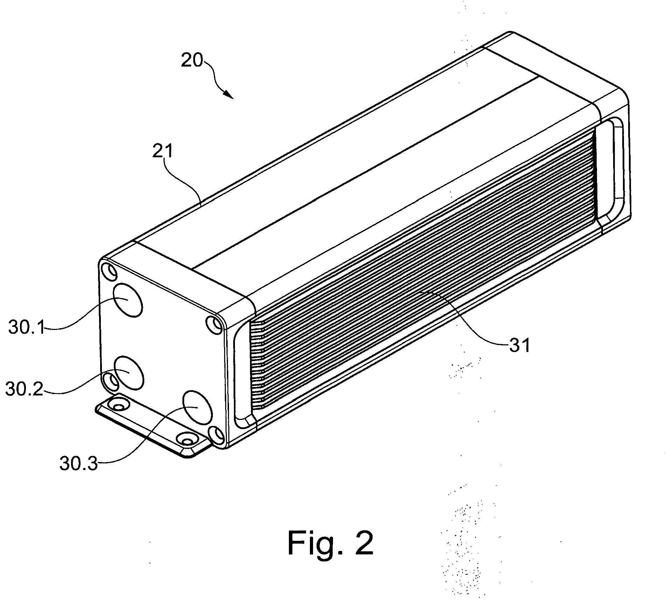

Figur 2 zeigt eine geschlossene Draufsicht auf ein Ausführungsbeispiel der Messeinheit 20 gemäß der vorliegenden Erfindung. Das Gehäuse 21 weist Kühlrippen 31 auf, die an der Längsseite des Gehäuses 21 angeordnet sind. An der Stirnseite des Gehäuses 21 sind drei Sensorausgänge 30.1, 30.2 und 30.3 angeordnet, über die die Messstrahlen aus der Messenheit ausgekoppelt und die reflektierte Strahlung detektiert werden können.

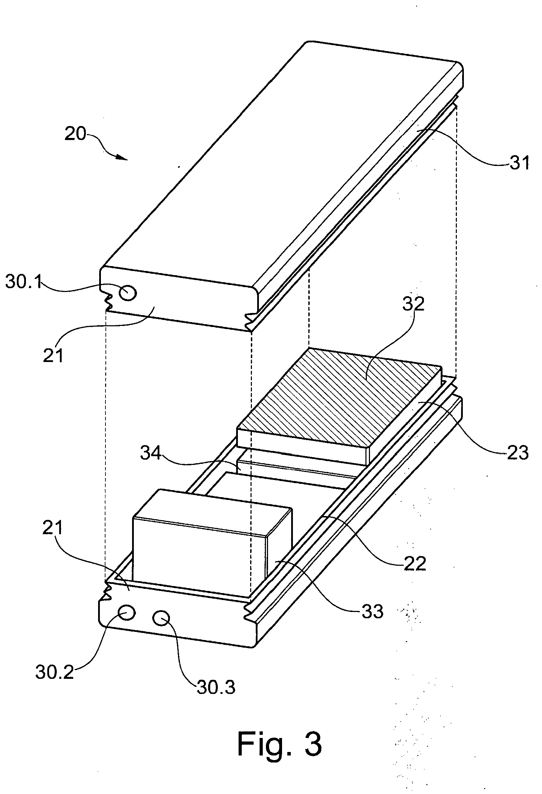

Figur 3 zeigt eine offene Draufsicht auf ein Ausführungsbeispiel der Messeinheit 20 gemäß der vorliegenden Erfindung. Das Gehäuse 21 weist wie in Figur 2 die Kühlrippen 31 und die Sensorausgänge 30.1, 30.2 und 30.3 auf. Daneben ist in dem Gehäuse 21 ein optisches Board 33 sowie ein Laser-Board 22 (mit Peltier-Element - nicht gesondert gezeigt) zu erkennen. Außerdem ist eine digitale Steuerung als FPGA 23 gezeigt, der über einem Interface-Board 34 angeordnet ist. Über eine Wärmeleitfolie 32 ist für die digitale Steuerung 23 ein Kontakt zur Wand des Gehäuses hergestellt.

Durch den Einsatz miniaturisierter Elektronik- und Optikkomponenten ist es möglich, die Gehäusegröße auf unter 50mm x 50mm x 165mm (Breite x Höhe x Länge) zu reduzieren. Hierbei sind die wärmeerzeugenden Komponenten (DFB-Laser 22, FPGA 23, Peltier-Element) thermisch mit dem Gehäuse 21verbunden und das Gehäuse 21 selbst wird als Kühlkörper verwendet (Kühlung über Konvektion). Diese Bauweise erlaubt nebst der genannten Quaderform auch andere Bauformen mit vergleichbarem Bauvolumen (zB flachere Bauweise für den Einsatz in Schaltschränken etc).

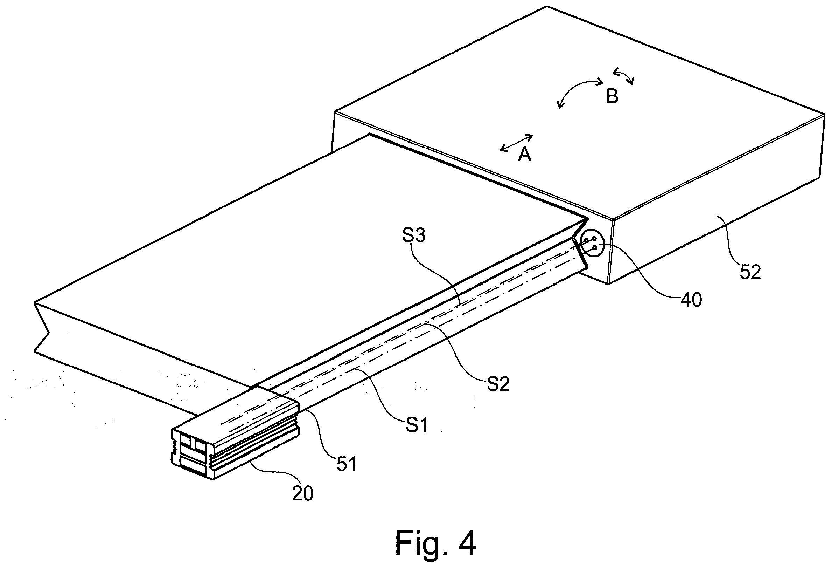

Figur 4 zeigt ein erstes Ausführungsbeispiel eines optischen Längenmesssystems zur Echtzeit-Messung zwischen einem ersten Maschinenteil 51 und einem zweiten Maschinenteil 52. Die beiden Maschinenteile 51, 52 sind gegeneinander über Laufschlitten in der Richtung des Pfeils A verfahrbar. Verfahrfehler wie Nicken und Gieren können entlang des Pfeiles B auftreten. An dem ersten Maschinenteil 51 ist eine Messeinheit 20 fest verschraubt. Die Messeinheit richtet drei Messtrahlen S1, S2 und S3 auf eine Reflektoreinheit 40, die fest mit dem zweiten Maschinenteil 52 verbunden ist. Durch die Beabstandung der drei Messpunkte auf der Reflektoreinheit 40 ist es möglich, sowohl eine Positionsveränderung zwischen dem ersten Maschinenteil 51 und dem zweiten Maschinenteil 52 entlang der Achse A zu messen, wie auch Verfahrfehler entlang der Achse B. Diese Messung kann sowohl in inkrementeller Art und Weise (Messung der Relativbewegung) als auch in absoluter Art und Weise erfolgen (Messung des Absolutabstands bzw der absoluten Verkippwinkel).

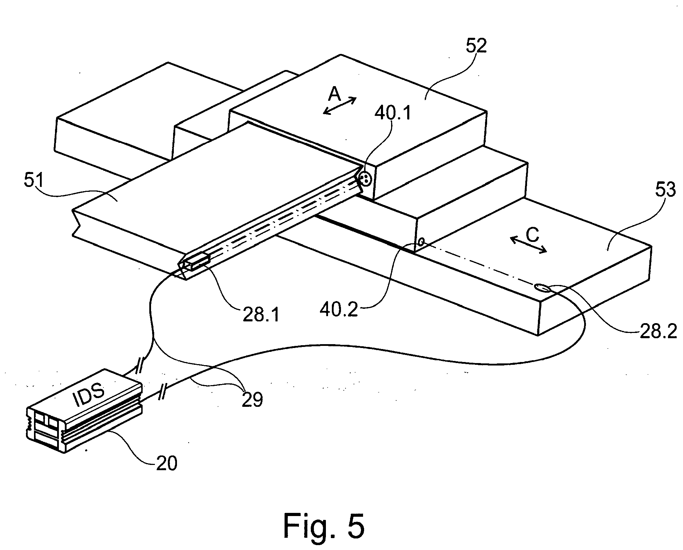

Figur 5 zeigt ein zweites Ausführungsbeispiel eines optischen Längenmesssystems zur Echtzeit-Messung zwischen einem ersten Maschinenteil 51, einem zweiten Maschinenteil 52 und einem dritten Maschinenteil 53. Die beiden Maschinenteile 51, 52 sind gegeneinander über Laufschlitten in der Richtung des Pfeils A verfahrbar. Die beiden Maschinenteile 53, 52 sind gegeneinander über Laufschlitten in der Richtung des Pfeils C verfahrbar. Eine Messeinheit 20 ist über Lichtwellenleiter 29 mit zwei fasergekoppelten Messköpfen 28.1 und 28.2 verbunden. Der Messkopf 28.1 ist auf dem ersten Maschinenteil 51 angebracht und auf eine Reflektoreinheit 40.1 auf dem zweiten Maschinenteil 52 ausgerichtet. Der Messkopf 28.2 ist auf dem dritten Maschinenteil 53 angebracht und auf eine Reflektoreinheit 40.2 auf dem zweiten Maschinenteil 52 ausgerichtet. Die Messeinheit 20 ist abgesetzt in einem Schaltschrank (nicht gezeigt) untergebracht.

Beim Verfahren der Schlitten in Richtung A und C messen nun die abgesetzten Messköpfe 28.1 und 28.2 die Relativbewegung bzw. die Absolutabstände zwischen den ersten 51 und zweiten 52 bzw. den zweiten 52 und dritten 53 Maschinenteilen. Die Glasfaser 29 erlaubt eine Anbindung der Messeinheit 20 in einem entfernten Raum - dieser kann mehr als 1.000 m entfernt von den Messköpfen 28.1 und 28.2 liegen.

Auf diese Weise ist ein Interferometer zur Echtzeitmessung von Absolutabständen und/oder relativen Positionsbewegungen zwischen einem ersten und einem zweiten Maschinenteil sowie ein optisches Längenmesssystem zum Messen von Absolutabständen und/oder relativen Positionsbewegungen zwischen einem ersten und einem zweiten Maschinenteil bereitgestellt worden, das die Nachteile des Standes der Technik vermeiden.

### Bezugszeichenliste:

- 10: Interferometer
- 20: Messeinheit/ Basismodul
- 21: Gehäuse
- 22: Laserquelle
- 23: digitale Steuerung
- 24: Peltier-Element
- 25: Spannungsreglermodul
- 26: Einrichtung zur Kompensation der Variation des Brechungsindexes der Luft
- 27: AD/DA-Wandler
- 28: abgesetzter (fasergekoppelter) Messkopf
- 29: Lichtwellenleiter
- 30: Sensorausgang
- 31: Kühlrippen
- 32: Wärmeleitfolie
- 33: Optisches Board
- 34: Interface-Board

- 40: Reflektoreinheit
- 50: Maschinenteil
- 51: erstes Maschinenteil
- 52: zweites Maschinenteil
- 53: drittes Maschinenteil

## Patentansprüche

1. Interferometer (10) zur Echtzeitmessung von Absolutabständen und/oder relativen Positionsbewegungen zwischen einem ersten und einem zweiten Maschinenteil,
umfassend eine Messeinheit (20) und eine Reflektoreinheit (40),
wobei die Reflektoreinheit (40) mindestens einen optischen Reflektor (41) umfasst;
wobei die Messeinheit (20) ein Gehäuse (21) mit mindestens einer Wand aus wärmeleitendem Material umfasst, wobei das wärmeleitende Material eine Wärmeleitfähigkeit *lambda* von mehr als 30 W/(m · K) bei 0°C aufweist,
wobei das Gehäuse (21) Außenabmessungen von weniger als 75 mm x 75 mm x 200 mm aufweist,
wobei in dem Gehäuse (21) mehrere Messelemente angeordnet sind,
wobei die Messelemente eine Laserquelle (22), ein Peltier-Element (24) und eine digitale Steuerung (23) umfassen,
wobei die Messelemente thermisch an der Wand des Gehäuses (21) aus wärmeleitendem Material angekoppelt sind, und
wobei die Messelemente faseroptische Komponenten und miniaturisierte Digitalelektronik umfassen; und
wobei das Gehäuse (21) in mindestens einem Bereich Kühlrippen aufweist, welche eine Thermalisierung mit den umgebenden Luftmassen befördert.

2. Interferometer (10) nach Anspruch 1, wobei die Messeinheit (20) einen abgesetzten Messkopf (28) umfasst, der mit der Messeinheit (20) mittels eines Lichtwellenleiters (29) gekoppelt ist.

3. Interferometer (10) nach einem der vorhergehenden Ansprüche, wobei die Messelemente ein Interface-Board, ein Field-Programmable-Gate-Array (FPGA)-Board, ein Laser-Board, und ein Optik-Board umfassen.

4. Interferometer (10) nach einem der vorhergehenden Ansprüche, wobei das wärmeleitende Material aus einem der folgenden Materialien oder einer Kombination hiervon besteht: Aluminium, Silber, Kupfer.

5. Interferometer (10) nach einem der vorhergehenden Ansprüche, wobei das Gehäuse (21) Außenabmessungen von weniger als 50 mm x 50 mm x 165 mm aufweist.

6. Interferometer (10) nach einem der vorhergehenden Ansprüche, wobei die Reflektoreinheit (40) mindestens drei optische Reflektoren (41.1, 41.2, 41.3) umfasst.

7. Interferometer (10) nach einem der vorhergehenden Ansprüche, wobei die digitale Steuerung (23) eingerichtet ist, eine Positionsermittlung der Reflektoreinheit (40) und/oder eine Temperatur- und Wellenlängenregelung durchzuführen.

8. Interferometer (10) nach einem der vorhergehenden Ansprüche, wobei das Interferometer (10) mit mindestens drei Messachsen versehen ist, insbesondere mit sechs Messachsen, wobei die digitale Steuerung eingerichtet ist, eine Verkippung, ein Nicken, ein Rollen, ein Gieren und einen Versatz zwischen den Maschinenteilen zu bestimmen.

9. Interferometer (10) nach einem der vorhergehenden Ansprüche, wobei zusätzlich eine Einrichtung (26) zur Kompensation der Variation des Brechungsindexes der Luft vorgesehen ist.

10. Optisches Längenmesssystem zum Messen von Absolutabständen und/oder relativen Positionsbewegungen zwischen einem ersten und einem zweiten Maschinenteil, wobei das optische Längenmesssystem aufweist:
das erste und das zweite Maschinenteil, sowie ein Interferometer nach einem der vorhergehenden Ansprüche, wobei:
das erste Maschinenteil (fest) mit der optoelektronischen Messeinheit (20) des Interferometers (10) verbunden ist; und
die Reflektoreinheit (30) des Interferometers (10) (fest) mit dem zweiten Maschinenteil verbundenen ist.

11. Optisches Längenmesssystem zum Messen von Absolutabständen und/oder relativen Positionsbewegungen zwischen einem ersten und einem zweiten Maschinenteil, wobei das optische Längenmesssystem aufweist:
das erste und das zweite Maschinenteil, sowie ein Interferometer nach einem der Ansprüche 2 bis 9, wobei:
das erste Maschinenteil mit dem abgesetzten Messkopf (28) verbundenen ist, der mit der Messeinheit (20) des Interferometers (10) fasergekoppelt ist; und
die Reflektoreinheit (30) des Interferometers (10) (fest) mit dem zweiten Maschinenteil verbundenen ist.

## Claims

1. Interferometer (10) for the real-time measurement of absolute distances and/or relative position movements between a first and a second machine part,
comprising a measurement unit (20) and a reflector unit (40),
wherein the reflector unit (40) comprises at least one optical reflector (41);
wherein the measurement unit (20) comprises a housing (21) with at least one wall made of heat-conducting material, wherein the heat-conducting material has a thermal conductivity *lambda* of more than 30 W/(m · K) at 0°C,
wherein the housing (21) has external dimensions of less than 75 mm x 75 mm x 200 mm,
wherein several measurement elements are arranged in the housing (21),
wherein the measurement elements comprise a laser source (22), a Peltier element (24) and a digital control (23),
wherein the measurement elements are thermally coupled to the wall of the housing (21) made of heat-conducting material, and
wherein the measurement elements comprise fibre-optic components and miniaturized digital electronics; and
wherein the housing (21) has cooling ribs in at least one region, which promotes thermalization with the surrounding air masses.

2. Interferometer (10) according to claim 1, wherein the measurement unit (20) comprises a remote measurement head (28) which is coupled to the measurement unit (20) by means of an optical waveguide (29).

3. Interferometer (10) according to one of the preceding claims, wherein the measurement elements comprise an interface board, a field programmable gate array (FPGA) board, a laser board, and an optics board.

4. Interferometer (10) according to one of the preceding claims, wherein the heat-conducting material consists of one of the following materials or a combination thereof: aluminium, silver, copper.

5. Interferometer (10) according to one of the preceding claims, wherein the housing (21) has external dimensions of less than 50 mm x 50 mm x 165 mm.

6. Interferometer (10) according to one of the preceding claims, wherein the reflector unit (40) comprises at least three optical reflectors (41.1, 41.2, 41.3).

7. Interferometer (10) according to one of the preceding claims, wherein the digital control (23) is set up to determine the position of the reflector unit (40) and/or to control temperature and wavelength.

8. Interferometer (10) according to one of the preceding claims, wherein the interferometer (10) is provided with at least three measurement axes, in particular with six measurement axes, wherein the digital control is set up to determine a tilt, pitch, roll, yaw and an offset between the machine parts.

9. Interferometer (10) according to one of the preceding claims, wherein a device (26) for compensating for the variation in the refractive index of the air is additionally provided.

10. Optical length measuring system for measuring absolute distances and/or relative position movements between a first and a second machine part, wherein the optical length measuring system has:
the first and the second machine part, as well as an interferometer according to one of the preceding claims, wherein:
the first machine part is (firmly) connected to the optoelectronic measurement unit (20) of the interferometer (10); and
the reflector unit (30) of the interferometer (10) is (firmly) connected to the second machine part.

11. Optical length measuring system for measuring absolute distances and/or relative position movements between a first and a second machine part, wherein the optical length measuring system has:
the first and the second machine part, as well as an interferometer according to one of claims 2 to 9, wherein:
the first machine part is connected to the remote measurement head (28) which is fibre-coupled to the measurement unit (20) of the interferometer (10); and
the reflector unit (30) of the interferometer (10) is (firmly) connected to the second machine part.

## Revendications

1. Interféromètre (10) pour la mesure en temps réel de distances absolues et/ou de mouvements relatifs entre une première et une deuxième partie de machine ;
comprenant une unité de mesure (20) et une unité de réflexion (40), l'unité de réflexion (40) comprenant au moins un réflecteur optique (41) ;
l'unité de mesure (20) comprenant un carter (21) avec au moins une paroi réalisée en matière thermoconductrice, la matière thermoconductrice comprenant une conductivité thermique lambda de plus de 30 W/(m · K) à 0 °C ;
le carter (21) présentant des dimensions extérieures inférieures à 75 mm x 75 mm x 200 mm ;
plusieurs éléments de mesure étant disposés dans le carter (21) ;
les éléments de mesure comprenant une source laser (22), un élément de Peltier (24) et une commande numérique (23) ; les éléments de mesure étant couplés thermiquement à la paroi du carter (21) réalisé en matière thermoconductrice ; et
les éléments de mesure comprenant des composants de fibre optique et un système électronique miniaturisé ; et
le carter (21) comportant des nervures de refroidissement dans au moins une région, ces nervures transportant un système de régulation thermique avec les masses d'air l'entourant.

2. Interféromètre (10) selon la revendication 1, l'unité de mesure (20) comprenant une tête de mesure (28) distante couplée à l'unité de mesure (20) à l'aide d'un conducteur d'ondes lumineuses (29).

3. Interféromètre (10) selon l'une quelconque des revendications précédentes, les éléments de mesure étant une carte interface (Interface Board en anglais), une carte de réseau de portes logiques programmable (Field Programmable Gate Array (FPGA) Board en anglais), une carte laser (Laser Board en anglais) et une carte optique.

4. Interféromètre (10) selon l'une quelconque des revendications précédentes, la matière thermoconductrice provenant d'une des matières suivantes ou d'une combinaison de celles-ci : aluminium, argent, cuivre.

5. Interféromètre (10) selon l'une quelconque des revendications précédentes, le carter (21) présentant des dimensions extérieures inférieures à 50 mm x 50 mm x 165 mm.

6. Interféromètre (10) selon l'une quelconque des revendications précédentes, l'unité de réflexion (40) comprenant au moins trois réflecteurs optiques (41.1, 41.2, 41.3).

7. Interféromètre (10) selon l'une quelconque des revendications précédentes, la commande numérique (23) étant conçue pour exécuter un calcul de position de l'unité de réflexion (40) et/ou un réglage de température et de longueur d'onde.

8. Interféromètre (10) selon l'une quelconque des revendications précédentes, l'interféromètre (10) étant pourvu d'au moins trois axes de mesure, notamment de six axes de mesure, la commande numérique étant conçue pour déterminer un basculement, un tangage, un roulement, une rotation ou un décalage entre les parties de machine.

9. Interféromètre (10) selon l'une quelconque des revendications précédentes, un dispositif (26) étant en outre prévu pour compenser la variation de l'indice de réfraction de l'air.

10. Système de mesure de longueur optique pour mesurer des distances absolues et/ou des mouvements relatifs entre une première et une deuxième partie de machine, le système de mesure de longueur optique comportant :
la première et la deuxième partie de machine ainsi qu'un interféromètre selon l'une quelconque des revendications précédentes :
la première partie de machine étant reliée (fixement) à l'unité de mesure optoélectronique (20) de l'interféromètre (10) ; et
l'unité de réflexion (30) de l'interféromètre (10) étant reliée (fixement) à la deuxième partie de machine.

11. Système de mesure de longueur optique pour mesurer des distances absolues et/ou des mouvements relatifs entre une première et une deuxième partie de machine, le système de mesure de longueur optique comportant :
la première et la deuxième partie de machine ainsi qu'un interféromètre selon l'une quelconque des revendications 2 à 9 :
la première partie de machine étant reliée à une tête de mesure (28) distante couplée par fibre à l'unité de mesure (20) de l'interféromètre (10) ; et
l'unité de réflexion (30) de l'interféromètre (10) étant reliée (fixement) à la deuxième partie de machine.
